# EUROPEAN PATENT SPECIFICATION

(11) **EP 3 388 870 B1**
(45) Date of publication and mention of the grant of the patent: **23.03.2022**
(21) Application number: 17202671.8
(22) Date of filing: 21.11.2017
(51) Int. Cl.: G02B 5/00, H01L 23/373, G02B 5/22, H01L 33/64, B82Y 30/00

(54) **COMPOSITE STRUCTURE AND METHOD FOR PRODUCING THE SAME AND ELECTRONIC DEVICE**
VERBUNDSTRUKTUR UND VERFAHREN ZUR HERSTELLUNG DAVON SOWIE ELEKTRONISCHE VORRICHTUNG
STRUCTURE COMPOSITE ET SON PROCÉDÉ DE PRODUCTION ET DISPOSITIF ÉLECTRONIQUE

(30) Priority: 12.04.2017 CN 201710236241; 12.04.2017 CN 201720383248 U
(43) Date of publication of application: 17.10.2018
(73) Proprietor: GUANGDONG OPPO MOBILE TELECOMMUNICATIONS CORP., LTD., Wusha, Chang'an Dongguan, Guangdong 523860 (CN)
(72) Inventor: OUYANG, Zhibin, Dongguan, Guangdong 523860 (CN)
(74) Representative: Romano, Giuseppe

(56) References cited:
- CN-A- 105 325 067
- CN-U- 205 800 354
- CN-U- 205 836 135
- CN-U- 206 014 744
- JP-U- 3 205 998
- US-A1- 2007 018 190
- US-A1- 2008 131 722
- US-A1- 2011 151 604
- US-A1- 2012 298 618

## Description

### FIELD

The present disclosure relates to the field of material technology, and more particular to a composite structure and a method for producing the same, and an electronic device having the same.

### BACKGROUND

With the continuous development of electronic devices, their diversified and intelligentized functions cause increasing power consumption. Furthermore, a light source on the electronic device will generate a lot of heat or useless light.

Therefore, how to effectively dissipate heat and absorb light for the electronic device at a low cost becomes an urgent problem to be solved.

CN 205 800 354 U relates to a composite heat radiation material of carbon dust + electrographite + metal forming.

CN 206 014 744 U relates to a nanometer carbon coating fin.

CN 105 325 067 A relates to a conductive heat-dissipating sheet.

### SUMMARY

According to embodiments of a first aspect of the present disclosure, there is provided a composite structure. The composite structure includes a first metal layer, a carbon nano-coating and a black coating. The carbon nano-coating is applied on a surface of the first metal layer. The black coating is applied on a surface of the carbon nano-coating opposite to the first metal layer.

In an embodiment of the present disclosure, the composite structure further includes a second metal layer, the first metal layer is attached to a surface of the second metal layer via an adhesive layer.

In an embodiment of the present disclosure, the adhesive layer is affixed to the first metal layer.

In an embodiment of the present disclosure, the second metal layer includes at least one selected from stainless steel, phosphor bronze, beryllium copper or copper-nickel-zinc alloy.

In an embodiment of the present disclosure, the first metal layer includes a copper foil.

In an embodiment of the present disclosure, the composite structure is strip-shaped.

In an embodiment of the present disclosure, the composite structure is a stretchable member.

In an embodiment of the present disclosure, the carbon nano-coating includes a carbon nanomaterial, and the carbon nanomaterial includes at least one selected from carbon nanotubes, carbon nanofibers or carbon nanospheres.

In an embodiment of the present disclosure, the carbon nano-coating is a hybrid coating, and the hybrid coating includes epoxy resin, graphene, carbon nanotubes, silicon carbide and boron nitride.

According to embodiments of a second aspect of the present disclosure, there is provided a method for producing a composite structure. The method includes: providing a first metal layer; applying a carbon nano-coating on a surface of the first metal layer; and applying a black coating on a surface of the carbon nano-coating opposite to the first metal layer.

In an embodiment of the present disclosure, the method further includes attaching the first metal layer to a surface of a second metal layer via an adhesive layer.

In an embodiment of the present disclosure, the carbon nano-coating is applied on the surface of the first metal layer and the black coating is applied on the surface of the carbon nano-coating opposite to the first metal layer by brush coating, spraying or dip coating.

In an embodiment of the present disclosure, the carbon nano-coating is applied on the surface of the first metal layer and the black coating is applied on the surface of the carbon nano-coating opposite to the first metal layer by at least one selected from physical sputtering, spin coating, inkjet printing or slit coating.

According to embodiments of a third aspect of the present disclosure, there is provided an electronic device. The electronic device includes at least one of a heat source or a light source, on which the composite structure described above or produced by the method described above is provided.

In an embodiment of the present disclosure, the first metal layer of the composite structure is attached to a surface of at least one of the heat source or the light source via an adhesive layer.

### BRIEF DESCRIPTION OF THE DRAWINGS

Fig. 1 is a schematic cross-sectional view of a composite structure according to an embodiment of the present disclosure.
Fig. 2 is a schematic cross-sectional view of a composite structure according to another embodiment of the present disclosure.
Fig. 3 is a schematic view of a composite structure according to yet another embodiment of the present disclosure.
Fig. 4 is a flow chart of a method for producing a composite structure according to an embodiment of the present disclosure.
Fig. 5 is a schematic view of an electronic device according to an embodiment of the present disclosure.

### DETAILED DESCRIPTION

In the following, technical solutions in embodiments of the present disclosure will be described clearly with reference to drawings. It should be appreciated that, the specific embodiments described herein are merely used to generally understand the present disclosure, but shall not be construed to limit the present disclosure. In addition, it should be illustrated that, for brief description, only parts of the structure related to the present disclosure, not all the structure, are shown in the drawings.

The terms "first", "second", and the like herein are used to distinguish different objects and are not refer to a specific sequence. In addition, It should be further understood that, when used in the specification, terms "including" and "containing" and any variations thereof specify the presence of stated features, operations, elements and/or components, but do not exclude the presence or addition of one or more other features, operations, elements, components and/or groups thereof. For example, a process, method, system, product or device including a series of steps or units is not limited to the listed steps or units, but may optionally further include steps or units not listed, or may optionally further include other steps or units inherent to the process, method, system, product or device.

Reference throughout this specification to "an embodiment," "some embodiments," "one embodiment", "another example," "an example," "a specific example," or "some examples," means that a particular feature, structure, material, or characteristic described in connection with the embodiment or example is included in at least one embodiment or example of the present disclosure. Thus, the appearances of the phrases such as "in some embodiments," "in one embodiment", "in an embodiment", "in another example," "in an example," "in a specific example," or "in some examples," in various places throughout this specification are not necessarily referring to the same embodiment or example of the present disclosure, or an independent or alternative embodiment or example mutually exclusive to other embodiments. Furthermore, it is explicitly or implicitly appreciated that, the particular features, structures, materials, or characteristics may be combined in any suitable manner in one or more embodiments or examples.

In embodiments of a first aspect of the present disclosure, there is provided a composite structure, including a first metal layer; a carbon nano-coating applied on a surface of the first metal layer; and a black coating applied on a surface of the carbon nano-coating opposite to the first metal layer.

In embodiments of a second aspect of the present disclosure, there is provided a method for producing a composite structure, including providing a first metal layer; applying a carbon nano-coating on a surface of the first metal layer; and applying a black coating on a surface of the carbon nano-coating opposite to the first metal layer.

In embodiments of a third aspect of the present disclosure, there is provided an electronic device, including at least one of a heat source or a light source, on which the composite structure described above or produced according to the above method is provided.

The electronic device according to embodiments of the present invention may be a digital product, a communication product, a household appliance and the like.

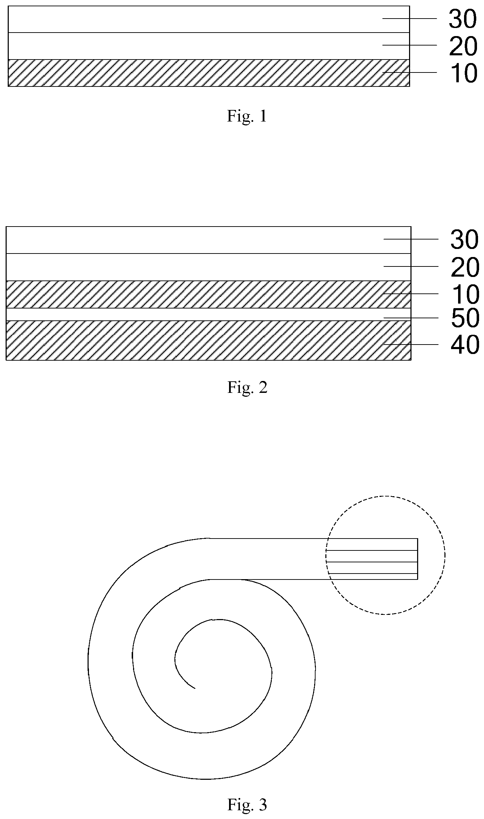

Referring to Fig. 1, which is a schematic cross-sectional view of a composite structure according to an embodiment of the present disclosure, the composite structure includes a first metal layer 10, a carbon nano-coating 20 and a black coating 30 formed sequentially.

The carbon nano-coating 20 is applied on a surface of the first metal layer 10, and the black coating 30 is applied on a surface of the carbon nano-coating 20 opposite to the first metal layer 10, i.e. on a surface of the carbon nano-coating 20 away from the first metal layer 10.

Alternatively, in an embodiment, the first metal layer 10 may include a copper foil, which has a good heat dissipation effect due to its good thermal conductivity. Certainly, in other embodiments, the first metal layer 10 may also include other materials with good thermal conductivity, such as an aluminum foil.

The carbon nano-coating 20 includes, but may not be limited to, carbon nanomaterials, which refer to carbon materials with at least one dimension less than 100 nm in the dispersed phase. The dispersed phase may be composed of either carbon atoms or heterogeneous atoms (non-carbon atoms), or even may be nanopores. Carbon nanomaterials mainly include three types: carbon nanotubes, carbon nanofibers, and carbon nanospheres.

Taking carbon nanotubes as an example, in practical application, the carbon nano-coating 20 may also be a hybrid coating including several materials. Alternatively, the carbon nano-coating 20 may be a hybrid coating including epoxy resin, graphene, carbon nanotubes, silicon carbide and boron nitride. Herein, the content of each component in the hybrid coating is not specifically limited.

A black body has the best radiation characteristic and can totally absorb and emit radiation in any wavelength at any temperature. Therefore, providing the black coating 30 may improve heat dissipation and light absorption efficiency.

In the above embodiments, an applying manner used among layers of the composite structure may be one of a brush coating method, a spraying method and a dip coating method. In other alternative embodiments, a physical or chemical deposition method, such as one or more selected from physical sputtering, spin coating, inkjet printing or slit coating, may also be used.

In practical application, the composite structure according to this embodiment is mainly attached on a surface of a heat source or a light source to dissipate heat or absorb light. For example, the composite structure may be disposed on a surface of a battery to dissipate heat, or disposed on a base of an LED lamp to dissipate heat and absorb light at the same time, or disposed on a rear shell of a display to dissipate heat.

Referring to Fig. 2, which is a schematic cross-sectional view of a composite structure according to another embodiment of the present disclosure, the composite structure includes a second metal layer 40, an adhesive layer 50, a first metal layer 10, a carbon nano-coating 20 and a black coating 30 arranged in a stacked manner.

The first metal layer 10 is attached to a surface of the second metal layer 40 via the adhesive layer 50.

Alternatively, the first metal layer 10 may include a copper foil, which has a good heat dissipation effect due to its good thermal conductivity. Certainly, in other embodiments, the first metal layer 10 may also include other materials with good thermal conductivity, such as an aluminum foil.

Alternatively, the carbon nano-coating 20 includes, but may not be limited to, carbon nanomaterials, which refer to carbon materials with at least one dimension less than 100 nm in the dispersed phase. The dispersed phase may be composed of either carbon atoms or heterogeneous atoms (non-carbon atoms), or even may be nanopores. Carbon nanomaterials mainly include three types: carbon nanotubes, carbon nanofibers, and carbon nanospheres.

Taking carbon nanotubes as an example, in practical application, the carbon nano-coating 20 may also be a hybrid coating including several materials. Alternatively, the carbon nano-coating 20 may be a hybrid coating including epoxy resin, graphene, carbon nanotubes, silicon carbide and boron nitride. Herein, the content of each component in the hybrid coating is not specifically limited.

Alternatively, a black body has the best radiation characteristic and can totally absorb and emit radiation in any wavelength at any temperature. Therefore, providing the black coating 30 may improve heat dissipation and light absorption efficiency.

Alternatively, the second metal layer 40 may include at least one selected from stainless steel, phosphor bronze, beryllium copper or copper-nickel-zinc alloy.

It should be appreciated that, in other alternative embodiments, the second metal layer 40 may also be a metal layer of a heat source or a light source. For example, the second metal layer 40 may be a base of an LED lamp, the first metal layer 10 may be directly attached on a surface of the base of the LED lamp via the adhesive layer 50 to achieve heat dissipating and light absorbing effects.

Referring to Fig. 3, which is a schematic view of a composite structure according to yet another embodiment of the present disclosure, a layer construction of the composite structure may be a construction as mentioned in the above two embodiments, and will not be elaborated herein.

For example, the composite structure includes an adhesive layer 50, a first metal layer 10, a carbon nano-coating 20 and a black coating 30 arranged in a stacked manner, and in this embodiment, the composite structure is strip-shaped.

Specifically, as shown in Fig. 3, the layer construction of the composite structure shown in the dotted circle may be as shown in Fig. 2, and will not be elaborated herein. As the copper foil, the carbon nano-coating and the black coating all may be made to be very thin, and are thus bendable.

In this embodiment, the composite structure is made into the strip structure, when used, the coiled strip may be directly unfolded and attached on a heat source or a light source. Therefore, the composite structure according to embodiments of the present disclosure has a higher production efficiency, a higher yield and a lower processing cost, as compared with the related art where attachment of graphite flakes, blackening treatment and the like are performed separately.

In addition, in other embodiment, the composite structure may also be made into a stretchable structure. For example, the composite structure is a stretchable member. As a surface of the heat source or the light source is not necessarily planar, a better attachment to a non-planar surface may be achieved by the stretchable composite structure.

Alternatively, the adhesive layer is affixed to the first metal layer. For example, the copper foil described in the above embodiments may be a copper foil tape which commonly includes an adhesive itself, and therefore an additional adhesive layer 50 may not be necessary.

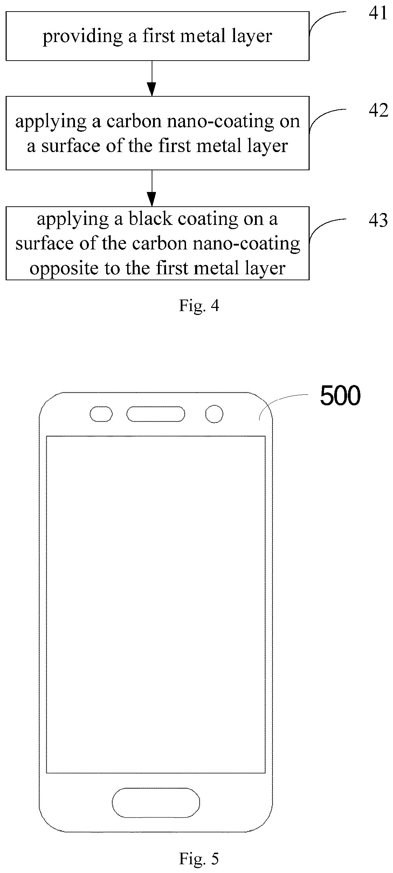

Referring to Fig. 4, which is a flow chart of a method for producing a composite structure according to an embodiment of the present disclosure, the method includes the followings.

At block 41: a first metal layer is provided.

Alternatively, the first metal layer may include a copper foil, which has a good heat dissipation effect due to its good thermal conductivity. Certainly, in other embodiments, the first metal layer may also include other materials with good thermal conductivity, such as an aluminum foil.

At block 42: a carbon nano-coating is applied on a surface of the first metal layer.

The carbon nano-coating includes, but may not be limited to, carbon nanomaterials, which refer to carbon materials with at least one dimension less than 100 nm in the dispersed phase. The dispersed phase may be composed of either carbon atoms or heterogeneous atoms (non-carbon atoms), or even may be nanopores. Carbon nanomaterials mainly include three types: carbon nanotubes, carbon nanofibers, and carbon nanospheres.

Taking carbon nanotubes as an example, in practical application, the carbon nano-coating may also be a hybrid coating including several materials. Alternatively, the carbon nano-coating may be a hybrid coating including epoxy resin, graphene, carbon nanotubes, silicon carbide and boron nitride. Herein, the content of each component in the hybrid coating is not specifically limited.

In some embodiments, the carbon nano-coating is applied on the surface of the first metal layer by brush coating, spraying or dip coating. In other embodiments, the carbon nano-coating is applied on the surface of the first metal layer by at least one selected from physical sputtering, spin coating, inkjet printing or slit coating.

At block 43: a black coating is applied on a surface of the carbon nano-coating opposite to the first metal layer.

A black body has the best radiation characteristic and can totally absorb and emit radiation in any wavelength at any temperature. Therefore, providing the black coating may improve heat dissipation and light absorption efficiency.

In some embodiments, the black coating is applied on the surface of the carbon nano-coating opposite to the first metal layer by brush coating, spraying or dip coating. In other embodiments, the black coating is applied on the surface of the carbon nano-coating opposite to the first metal layer by at least one selected from physical sputtering, spin coating, inkjet printing or slit coating.

Alternatively, in another embodiment, after block 43, the method may further include attaching the first metal layer to a surface of a second metal layer via an adhesive layer.

The second metal layer may include at least one selected from stainless steel, phosphor bronze, beryllium copper or copper-nickel-zinc alloy.

Alternatively, in yet another embodiment, before block 41, the method may further include attaching the first metal layer to a surface of a second metal layer via an adhesive layer.

In the following, the above embodiments will be illustrated with reference to two specifically practical applications.

In an example of the first practical application, a copper foil tape may be firstly attached to a heat source or a light source, and then a carbon nano-coating and a black coating are applied on a surface of the copper foil tape.

In an example of the second practical application, a composite tape may be prepared first, i.e. the composite tape includes an adhesive layer, a copper foil layer, a carbon nano-coating and a black coating. When in use, the composite tape is attached to a heat source or a light source.

It should be appreciated that, the layer construction of the composite structure mentioned in the above examples is merely exemplary, and the layer constructions described in the above embodiments with respect to the composite structure may be applied in the above examples.

Referring to Fig. 5, which is a schematic view of an electronic device according to an embodiment of the present disclosure, the electronic device 500 includes at least one of a light source or a heat source (not shown in Fig. 5) on which a composite structure is provided.

The light source of the electronic device 500 may be a camera, a backlight module of a display screen, etc.; and the heat source of the electronic device 500 may be a battery, a circuit board, a sensor, etc.

It should be appreciated that, the composite structure in this embodiment may be the composite structure as described in the above composite structure embodiments or the composite structure produced by the method described in the above method embodiments, their principles and structures are similar, and will not be elaborated herein.

In the above manners, the composite structure according to any one of embodiments of the present disclosure may have heat dissipation and light absorption effects on the light source and the heat source of the electronic device, and may have lowered production cost and improved product yield.

The composite structure and the method for producing the same and the electronic device according to embodiments of the present disclosure are described in detail hereinbefore. Principles and implementation manners of the present disclosure are explained in detail with some specific examples. The invention is defined by the appended set of claims.

## Claims

1. A composite structure for heat dissipation or light absorption, comprising:
a first metal layer (10);
a carbon nano-coating (20) applied on a surface of the first metal layer (10);
a black coating (30) applied on a surface of the carbon nano-coating (20) opposite to the first metal layer (10); and
a second metal layer (40), wherein the first metal layer (10) is attached to a surface of the second metal layer (40) via an adhesive layer (50),
wherein the adhesive layer (50) is affixed to the first metal layer (10).

2. The composite structure according to claim 1, wherein the second metal layer (40) comprises at least one selected from stainless steel, phosphor bronze, beryllium copper or copper-nickel-zinc alloy.

3. The composite structure according to claim 1 or 2, wherein the first metal layer (10) comprises a copper foil.

4. The composite structure according to any one of claims 1 to 3, wherein the composite structure is strip-shaped.

5. The composite structure according to any one of claims 1 to 4, wherein the composite structure is a stretchable member.

6. The composite structure according to any one of claims 1 to 5, wherein the carbon nano-coating (20) comprises a carbon nanomaterial, and the carbon nanomaterial comprises at least one selected from carbon nanotubes, carbon nanofibers or carbon nanospheres.

7. The composite structure according to any one of claims 1 to 6, wherein the carbon nano-coating (20) is a hybrid coating comprising epoxy resin, graphene, carbon nanotubes, silicon carbide and boron nitride.

8. A method for producing a composite structure for heat dissipation or light absorption, comprising:
providing a first metal layer (10);
applying a carbon nano-coating (20) on a surface of the first metal layer (10);
applying a black coating (30) on a surface of the carbon nano-coating (20) opposite to the first metal layer (10); and
attaching the first metal layer (10) to a surface of a second metal layer (40) via an adhesive layer (50).

9. The method according to claim 8, wherein the carbon nano-coating (20) is applied on the surface of the first metal layer (10) and the black coating (30) is applied on the surface of the carbon nano-coating (20) opposite to the first metal layer (10) by brush coating, spraying or dip coating.

10. The method according to claim 8, wherein the carbon nano-coating (20) is applied on the surface of the first metal layer (10) and the black coating (30) is applied on the surface of the carbon nano-coating (20) opposite to the first metal layer (10) by at least one selected from physical sputtering, spin coating, inkjet printing or slit coating.

11. An electronic device (500), comprising at least one of a heat source or a light source, on which the composite structure according to any one of claims 1 to 7 is provided.

## Patentansprüche

1. Verbundstruktur zur Wärmeableitung oder Lichtabsorption, umfassend:
eine erste Metallschicht (10);
eine Kohlenstoffnanobeschichtung (20), die auf eine Oberfläche der ersten Metallschicht (10) aufgebracht ist;
eine schwarze Beschichtung (30), die auf eine Oberfläche der Kohlenstoffnanobeschichtung (20) gegenüber der ersten Metallschicht (10) aufgebracht ist; und
eine zweite Metallschicht (40), wobei die erste Metallschicht (10) mittels einer Klebeschicht (50) an einer Oberfläche der zweiten Metallschicht (40) befestigt ist,
wobei die Klebeschicht (50) an der ersten Metallschicht (10) angebracht ist.

2. Verbundstruktur nach Anspruch 1, wobei die zweite Metallschicht (40) mindestens eines ausgewählt aus rostfreiem Stahl, Phosphorbronze, Berylliumkupfer oder Kupfer-Nickel-Zink-Legierung umfasst.

3. Verbundstruktur nach Anspruch 1 oder 2, wobei die erste Metallschicht (10) eine Kupferfolie umfasst.

4. Verbundstruktur nach einem der Ansprüche 1 bis 3, wobei die Verbundstruktur streifenförmig ist.

5. Verbundstruktur nach einem der Ansprüche 1 bis 4, wobei die Verbundstruktur ein reckbares Element ist.

6. Verbundstruktur nach einem der Ansprüche 1 bis 5, wobei die Kohlenstoffnanobeschichtung (20) ein Kohlenstoffnanomaterial umfasst, und wobei das Kohlenstoffnanomaterial mindestens eines ausgewählt aus Kohlenstoffnanoröhrchen, Kohlenstoffnanofasern oder Kohlenstoffnanokügelchen umfasst.

7. Verbundstruktur nach einem der Ansprüche 1 bis 6, wobei die Kohlenstoffnanobeschichtung (20) eine Hybridbeschichtung ist, die Epoxyharz, Graphen, Kohlenstoffnanoröhrchen, Siliciumcarbid und Bornitrid umfasst.

8. Verfahren zur Herstellung einer Verbundstruktur zur Wärmeableitung oder Lichtabsorption, umfassend:
Bereitstellen einer ersten Metallschicht (10);
Aufbringen einer Kohlenstoffnanobeschichtung (20) auf eine Oberfläche der ersten Metallschicht (10);
Aufbringen einer schwarzen Beschichtung (30) auf eine Oberfläche der Kohlenstoffnanobeschichtung (20) gegenüber der ersten Metallschicht (10); und
Befestigen der ersten Metallschicht (10) an einer Oberfläche einer zweiten Metallschicht (40) mittels einer Klebeschicht (50).

9. Verfahren nach Anspruch 8, wobei die Kohlenstoffnanobeschichtung (20) auf die Oberfläche der ersten Metallschicht (10) aufgebracht wird und die schwarze Beschichtung (30) auf die Oberfläche der Kohlenstoffnanobeschichtung (20) gegenüber der ersten Metallschicht (10) durch Aufbürsten, Sprühen oder Tauchbeschichten aufgebracht wird.

10. Verfahren nach Anspruch 8, wobei die Kohlenstoffnanobeschichtung (20) auf die Oberfläche der ersten Metallschicht (10) aufgebracht wird und die schwarze Beschichtung (30) auf die Oberfläche der Kohlenstoffnanobeschichtung (20) gegenüber der ersten Metallschicht (10) durch mindestens eines ausgewählt aus physikalischem Sputtern, Schleuderbeschichten, Tintenstrahldruck oder Schlitzbeschichten aufgebracht wird.

11. Elektronische Vorrichtung (500), umfassend mindestens eine von einer Wärmequelle oder einer Lichtquelle, auf der die Verbundstruktur nach einem der Ansprüche 1 bis 7 bereitgestellt wird.

## Revendications

1. Structure composite pour la dissipation de chaleur ou l'absorption de lumière, comprenant :
une première couche métallique (10) ;
un nano-revêtement (20) de carbone appliqué sur une surface de la première couche métallique (10) ;
un revêtement noir (30) appliqué sur une surface du nano-revêtement (20) de carbone à l'opposé de la première couche métallique (10) ; et
une deuxième couche métallique (40), la première couche métallique (10) étant fixée à une surface de la deuxième couche métallique (40) via une couche d'adhésif (50),
la couche d'adhésif (50) étant fixée à la première couche métallique (10).

2. Structure composite selon la revendication 1, la deuxième couche métallique (40) comprenant au moins un choisi parmi un acier inoxydable, un bronze phosphoreux, un alliage béryllium cuivre ou cuivrenickel-zinc.

3. Structure composite selon la revendication 1 ou 2, la première couche métallique (10) comprenant une feuille de cuivre.

4. Structure composite selon l'une quelconque des revendications 1 à 3, la structure composite étant sous forme de bande.

5. Structure composite selon l'une quelconque des revendications 1 à 4, la structure composite étant un élément étirable.

6. Structure composite selon l'une quelconque des revendications 1 à 5, le nano-revêtement (20) de carbone comprenant un nanomatériau de carbone, et le nanomatériau de carbone comprenant au moins l'un choisi parmi des nanotubes de carbone, des nanofibres de carbone et des nanosphères de carbone.

7. Structure composite selon l'une quelconque des revendications 1 à 6, le nano-revêtement (20) de carbone étant un revêtement hybride comprenant une résine époxy, du graphène, des nanotubes de carbone, du carbure de silicium et du nitrure de bore.

8. Procédé pour la production d'une structure composite pour la dissipation de chaleur ou l'absorption de lumière, comprenant :
la mise à disposition d'une première couche métallique (10) ;
l'application d'un nano-revêtement (20) de carbone sur une surface de la première couche métallique (10) ;
l'application d'un revêtement noir (30) sur une surface du nano-revêtement (20) de carbone à l'opposé de la première couche métallique (10) ; et
la fixation de la première couche métallique (10) à une surface d'une deuxième couche métallique (40) via une couche d'adhésif (50).

9. Procédé selon la revendication 8, le nano-revêtement (20) de carbone étant appliqué sur la surface de la première couche métallique (10) et le revêtement noir (30) étant appliqué sur la surface du nano-revêtement (20) de carbone à l'opposé de la première couche métallique (10) par revêtement par brossage, par pulvérisation ou par revêtement par trempage.

10. Procédé selon la revendication 8, le nano-revêtement (20) de carbone étant appliqué sur la surface de la première couche métallique (10) et le revêtement noir (30) étant appliqué sur la surface du nano-revêtement (20) de carbone à l'opposé de la première couche métallique (10) par au moins l'un choisi parmi une pulvérisation physique, un revêtement par centrifugation, une impression par jet d'encre ou un revêtement à fente.

11. Dispositif électronique (500), comprenant au moins l'un parmi une source de chaleur et une source de lumière, sur lequel la structure composite selon l'une quelconque des revendications 1 à 7 est appliquée.
